# EUROPEAN PATENT SPECIFICATION

(11) **EP 3 308 174 B1**
(45) Date of publication and mention of the grant of the patent: **21.08.2019**
(21) Application number: 16734750.9
(22) Date of filing: 14.06.2016
(51) Int. Cl.: G01R 1/36, G01R 15/04, G01R 21/133

(54) **DEVICE FOR MEASURING THE ELECTRIC POWER DRAWN BY A RAILWAY VEHICLE FROM A HIGH-VOLTAGE ELECTRIC SUPPLY LINE**
VORRICHTUNG ZUM MESSEN DES DURCH EIN SCHIENENFAHRZEUG AUS EINER HOCHSPANNUNGSVERSORGUNGSLEITUNG AUFGENOMMENEN STROMS
DISPOSITIF POUR MESURER LA PUISSANCE ÉLECTRIQUE PRÉLEVÉE PAR UN VÉHICULE DE CHEMIN DE FER SUR UNE LIGNE D'ALIMENTATION ÉLECTRIQUE À HAUTE TENSION

(30) Priority: 15.06.2015 IT UB20151379
(43) Date of publication of application: 18.04.2018
(73) Proprietor: Microelettrica Scientifica S.p.A., 20090 Buccinasco (MI) (IT)
(72) Inventor: BATTISTELLA, Denis, I-20037 Paderno Dugnano (Milano) (IT); CHIANESE, Alessandro, I-20024 Garbagnate Milanese (Milano) (IT)
(74) Representative: Deambrogi, Edgardo
(86) International application number: PCT/IB2016/053487
(87) International publication number: WO 2016/203360

(56) References cited:
- JP-A- 2002 214 254
- US-A1- 2010 006 385
- US-A9- 2009 128 122

## Description

The present invention relates to a device for measuring the electric power delivered to a railway vehicle by a high-voltage electric supply line.

More specifically, the invention relates to a device for measuring the electrical power drawn by a railway vehicle comprising:
current sensing means, connected operationally to said electric supply line,
a resistive voltage divider connected operationally between said supply line and an electric earthing terminal,
first processing means connected to said current sensing means and designed to generate signals or data indicating the intensity of the current drawn by the vehicle from the supply line, and
second processing means connected to the output of said divider and designed to generate signals or data indicating the voltage of said supply line.

A device of this type is described for example in European patent application EP 1 882 954 A1. In the device described in said document, the current sensing means, the voltage divider and the processing means related thereto are seated in an upper cavity (or high-voltage area) inside the insulator, separated by a second cavity (or low-voltage area) formed in the lower portion of the same insulator, which furthermore contains an electrical-to-optical energy converter designed to send power to said processing means, as well as optical/electrical converters that provide signals/data indicating the voltage and relevant current.

US 2010/006385 discloses an electrical equipment arranged in the roof of an electrically driven railway vehicle equipped with at least one pantograph and a roof line conveying the current received from a catenary line from the connection to said pantograph to the electrical driving devices of the vehicle, wherein the electrical equipment is arranged on a mechanical support and comprises a circuit-breaking device for protecting said electrical driving devices. The electrical equipment includes a measuring device comprising at least means for measuring the amperage of the current transmitted from the catenary to the roof line, which means are arranged on said mechanical support, and a computer which controls the actuation of said circuit-breaking device.

One objective of the present invention is to provide a device for measuring the electrical power drawn by a railway vehicle having and innovative architecture that in particular provides high levels of safety, even in the presence of significant surge voltages.

This and other objectives are achieved according to the invention using a measuring device of the type initially specified, in which:
the terminal with the lowest potential of the voltage divider is connected to a plate-like member made of electrically conductive material that extends outside the cavity of said line insulator, and
at a lower end of said insulator there is connected a hollow body made of electrically conductive material, designed to be connected to earth and in which there are arranged said second processing means, said hollow body including a plate-like wall facing said plate-like member at a predetermined distance therefrom, such as to form therewith a discharger capable of generating an electric discharge when the voltage at the ends of same exceeds a predetermined value.

This solution provides a device for measuring the electrical power drawn from the high-voltage electric supply line, in accordance with prevailing standards and in particular standard EN50463.

Further characteristics and advantages of the present invention are set out in the detailed description below, provided purely as a non-limiting example, with reference to the attached drawings, in which:
- Figure 1 is a perspective view of an electrical-power measuring device according to the present invention,
- Figure 2 is a circuit diagram with blocks showing a measuring device according to the present invention,
- Figure 3 is a partial perspective bottom view of the measuring device according to Figure 1,
- Figure 4 is a vertical cross-section taken along the line IV-IV in Figure 1, and
- Figure 5 is a partial magnified cut-out view of the lower portion in Figure 4.

In the drawings, reference sign 1 indicates a device as a whole according to the present invention for measuring the electrical power delivered from a high-voltage electric supply line to a railway vehicle.

The electric supply line is for example a 25 kV AC (50 Hz) line, or a 15 kV AC (16 + 2/3 Hz) line, or a 3 kV DC line.

In the example embodiment shown, the measuring device 1 includes a conventional line insulator 2 on top of which is mounted an upper container indicated as a whole using reference sign 3 and at the base of which is attached a lower base or container 4.

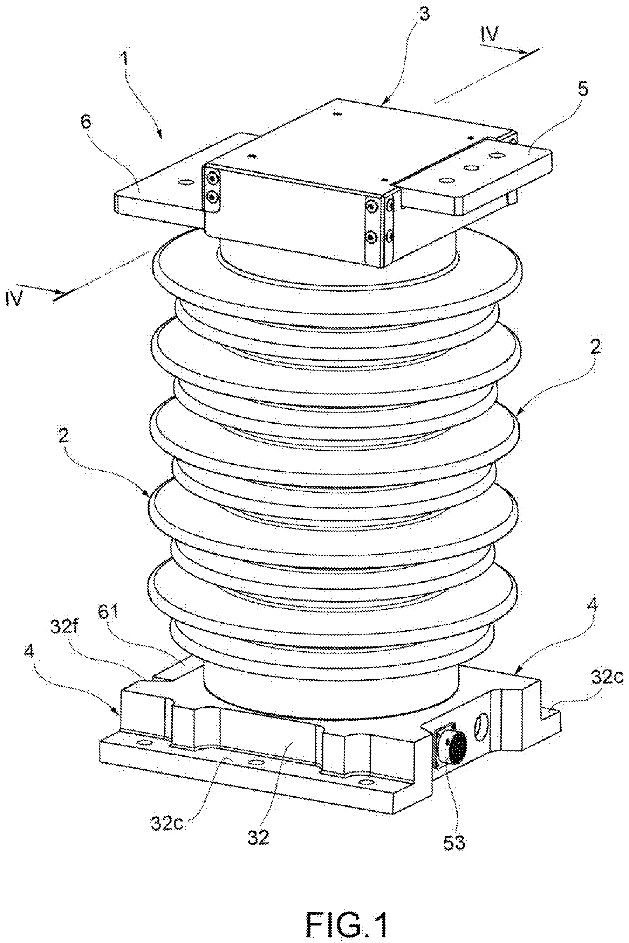

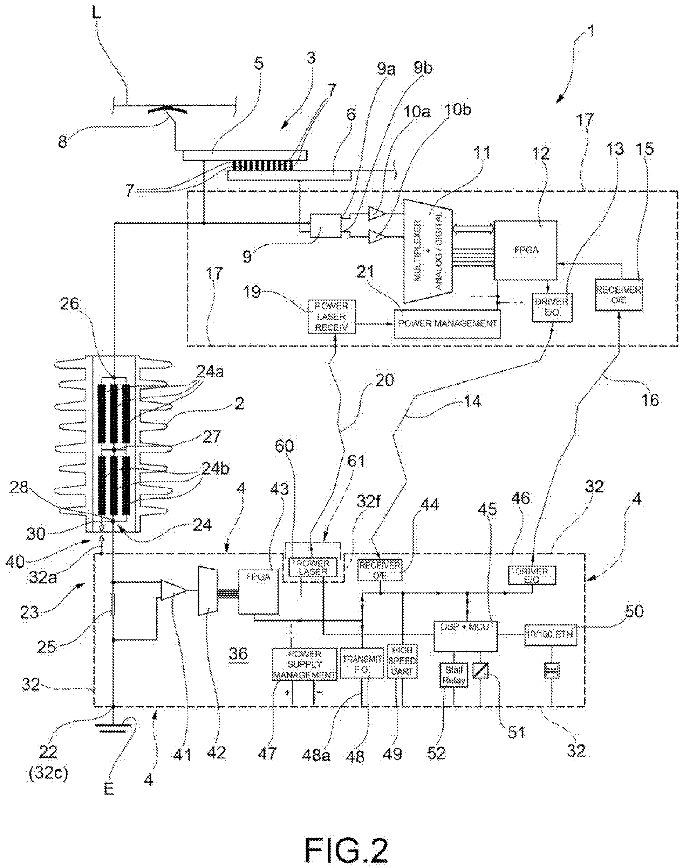

With reference to Figures 1, 2 and 4, the upper container 3 contains an upper horizontal metal plate 5 and a lower horizontal metal plate 6 that partially face one another (Figure 2).

Between the facing portions of the plates 5 and 6 there is a plurality of pins 7 that are electrically connected to one another in parallel to jointly form a shunt resistor of predetermined value, for example around 10 µΩ.

As shown schematically in Figure 2, the upper metal plate 5 is designed to be operationally connected to a high-voltage electric supply line L, for example via a pantograph 8. Conversely, the lower metal plate 6 is designed to be connected to the traction motors.

As shown in Figure 2, the plates 5 and 6, or the terminals of the shunt resistor formed by the pins 7 in parallel, are connected to the input of a processing and amplification circuit 9. This circuit 9 provides a signal indicating the AC voltage on the catenary L to an output 9a and a signal indicating the DC voltage on said catenary to an output 9b.

The signals outputted by the circuits 9 pass via respective amplifiers 10a, 10b to corresponding inputs of a block 11 acting as multiplexer and analogue/digital converter. This latter is connected to and controlled by a control and processing unit provided for example using a field programmable gate array (FPGA) 12.

The control and processing unit 12 is connected to the input of a electrical/optical driver (converter) 13, the output of which is coupled to an optical fibre 14.

The unit 12 is also connected to the output of a electrical/optical receiver/converter 15, the input of which is coupled to an optical fibre 16.

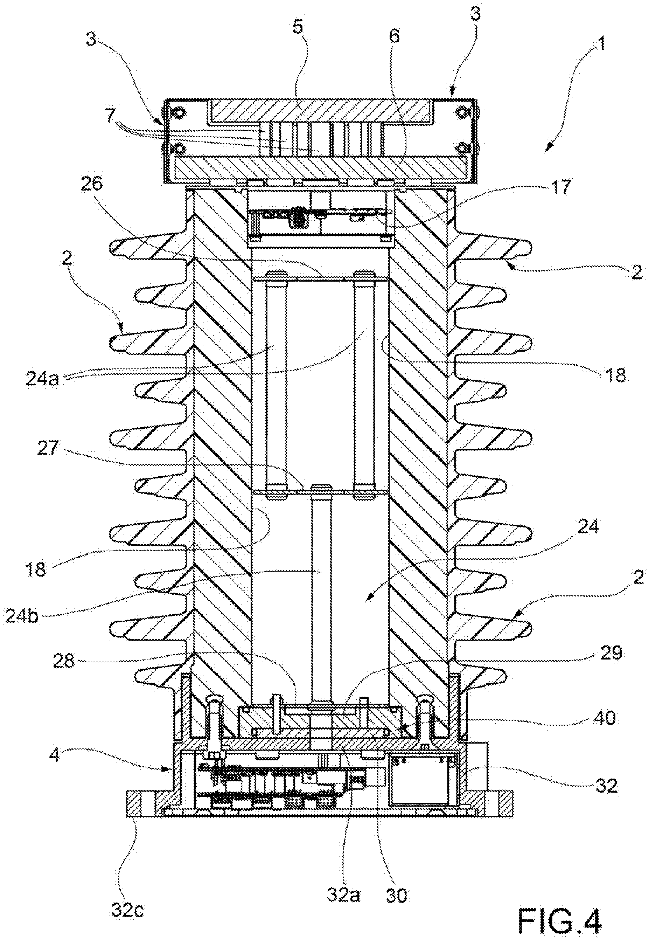

Although in the diagram in Figure 2 the discriminator 9, the amplifiers 10a, 10b, the A/D converter-multiplexer 11, the unit 12 and the converters 13 and 15 are shown as being outside the insulator 2, in fact these devices (and others described below) are carried on a circuit board 17 mounted in the upper end portion of the axial cavity 18 formed in the insulator 2 (see Figure 4).

With reference to Figure 2, the direct supply voltages required by the devices carried on the circuit board 17 are obtained by a power laser receiver 19 that uses an optical fibre 20 to receive a power laser beam (for example 2 W), converting the optical energy into electrical energy, which it supplies to a supply-voltage management unit 21. The laser receiver 19 and the unit 21 are advantageously carried on the same circuit board 17.

In an embodiment not shown in the drawings, the optical fibres 14, 16 and 20 extend inside the cavity 18 of the insulator 2, from the converters 13, 15 and 19 carried on the board 17 to the components (which are described below) seated inside the base body 4.

With reference to Figure 2, a resistive voltage divider, indicated as a whole using reference sign 23, is connected between the board 5 and a terminal 22 that is designed to be connected to earth.

In the embodiment shown, the voltage divider 23 includes an upper resistor group 24 and a lower measurement resistor 25, connected together in series.

The upper resistor group 24 in the example embodiment shown includes three upper resistors 24a connected together in parallel and connected in series with three lower resistors 24b, which are in turn connected together in parallel. As a whole, the upper resistor group 24 has a resistance of around 50 MΩ.

With reference to Figure 4, in the example embodiment shown, the resistors 24a have respective upper ends connected to a metal connection ring 26 and lower ends connected to an intermediate metal connection ring 27, which is also connected to the upper ends of the resistors 24b. The lower ends of these latter are connected to a lower metal ring 28.

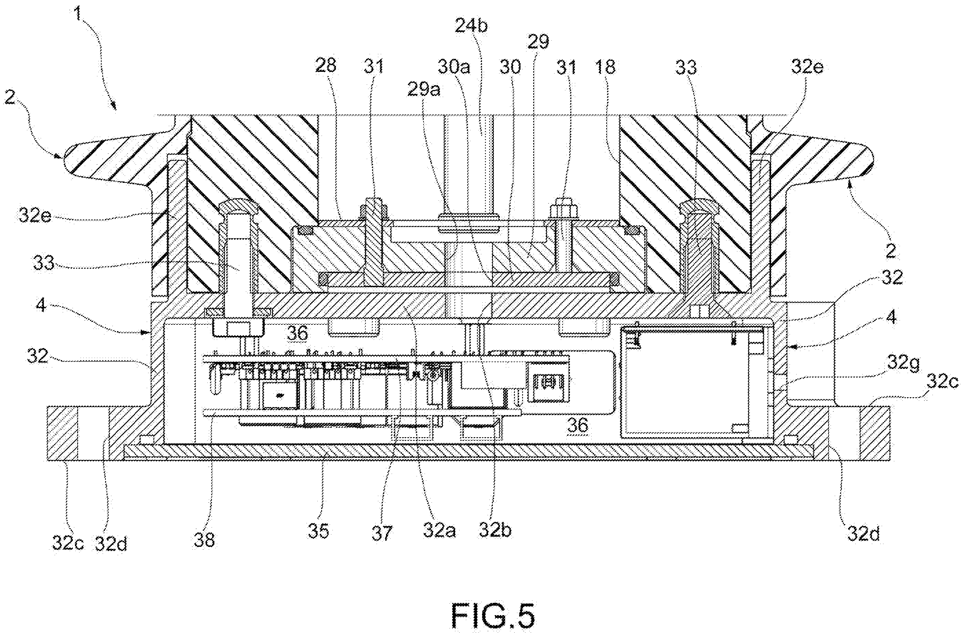

The ring 28 is attached to an electrically insulating material 29, that is essentially disc shaped, that closes the bottom of the cavity 18 formed inside the insulator 2 (see also Figure 5).

The disc-shaped element 29 has at least one central opening 29a.

As shown in Figures 4 and 5, the upper resistor group 24 of the divider 23 extends completely inside the cavity 18 of the insulator 2.

With particular reference to Figure 5, a plate-like member 30 made of electrically conductive material, which advantageously also has a central opening 30a, is attached to the lower face of the disc-shaped element 29.

The plate-like member 30 is electrically and mechanically connected to the conductive ring 28 by means of a plurality of pins 31 that pass through the insulating disc member 29.

The base 4 in the embodiment illustrated includes a metal body 32 substantially shaped like an inverted pan, the back wall 32a is attached to the lower end of the insulator 2 by means of bolts 33 or similar and also has a central opening 32b.

The body 33 is closed at the bottom by a cover, indicated using reference sign 35 in Figure 5, in which the cavity or chamber formed inside said body 32 is indicated using reference sign 36.

In the embodiment illustrated, the lower portion of the body 32 has a pair of horizontal fins 32c projecting transversely outwards and including respective holes 32d used for attachment to an earthing conductor.

On the side opposite the fins 32c, the body 32 has a tubular cylindrical extension 32e, inserted into a corresponding annular hollow formed in the wall of the insulator 2 (see Figure 5).

The central portion of the back wall 32a of the metal container 32 is oriented to face the plate-like member 30, from which it is separated by a predetermined calibrated distance.

As a whole, the plate-like member 30 and the body 32 (and in particular the wall 32a of this latter) form a discharger, shown schematically and indicated as a whole using reference sign 40 in Figure 2, between the terminal 28 with the lowest potential in the upper resistor group 24 and earth E.

In the event of a surge that exceeds a predetermined value, between the plate-like member 30 and the wall 32a of the container 32, an electrical charge is generated that prevents damage being caused to the devices seated in the cavity 36 of the base 4, 32, which are described in greater detail below.

Two circuit boards 37 and 38, bearing various different devices and that are described below with reference to the diagram in Figure 2, are assembled in the cavity 36 formed in the base 4, or inside the pan-shaped body 32.

As shown in this diagram, the measurement resistor 25, which has a resistance of for example approximately 3 kΩ, is assembled in the base 4.

An amplifier 41 is connected to the ends of said resistor 25, the output of the amplifier is connected to an A/D converter 42, coupled to a control and processing unit 43, which is also for example an FPGA.

Reference sign 44 in Figure 2 indicates a receiver (electrical/optical converter) the input of which is connected to the optical fibre 14 through which the control and processing unit 12 sends data indicating the intensity of the current measured using the shunt resistor 5-7.

The output of the receiver 24 is connected to a unit 45, formed for example using a DSP device and a microcontroller. This unit 45 also receives the data sent by the unit 43, indicating the voltage of the line L, measured using the resistive divider 23.

The unit 45 is also connected to a transmitter (electrical/optical converter) 46, the output of which is connected to the optical fibre 16 in order to send synchronism data to the control and processing unit 12.

Various other devices may be provided inside the base 4, such as a power unit 47 used to supply voltage to the different devices in the base 4, an electrical/optical transmitter/converter 48 with an optical fibre output 48a for connection to external equipment, a UART unit 49 for connecting external devices, a network communication interface (for example Ethernet) 50, an interface 51, for example an RS-485 interface, and a relay output 52.

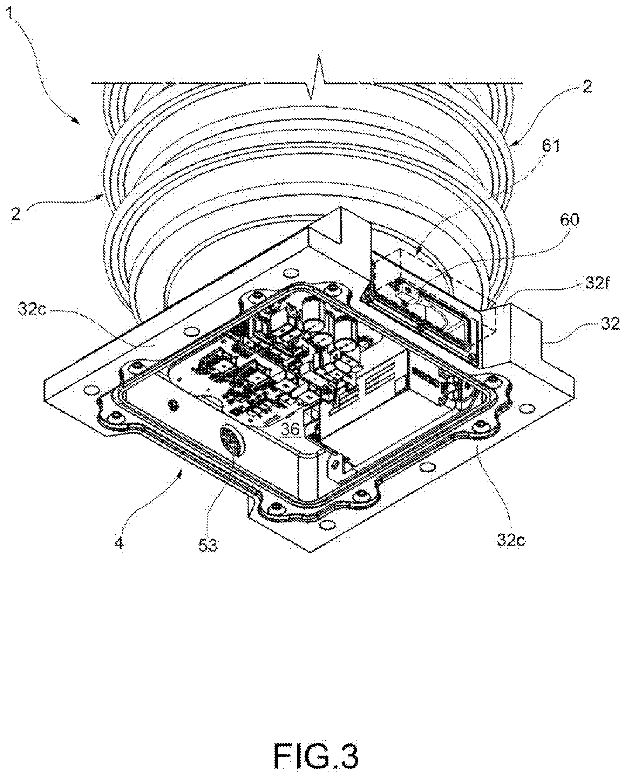

The electrical connections of the devices inside the base 4 with the "outside world" can advantageously be provided using a multi-pole electrical connector, such as the one indicated using reference sign 53 in Figures 1 and 3.

The base 4 also includes an energy source in the form of a source of optical radiation, such as a solid-state laser generator or one or more LEDs.

In the embodiment illustrated, this energy source is a device for generating a power laser beam 60 (Figures 2 and 3), that is always, seated outside the cavity 36 formed in the body 32 of said base. In the embodiment illustrated, this laser generation device 60 is seated in an external recess 32f of the body 32 and is covered and protected by a shaped cover 61 (Figures 1, 2 and 3) attached removably to the body 32.

Indeed, the service life of existing solid-state laser radiation generating devices is considerably shorter than the anticipated service life of the device for measuring electrical power 1 according to the invention, on account of which it may be necessary to replace such a generator during the service life of said measuring device.

To facilitate and reduce the cost of replacing the laser generator 60, according to the invention said device is seated outside the base 4 such that it can be quickly reached and replaced by simply removing the protective cover 61.

In a modified embodiment, the optical energy source may be built into the protective cover 61.

Figure 5 also shows that the cavity 36 inside the body 32 of the base 4 communicates with the outside via one or more openings 32g.

When in operation, the measuring device 1 described above works essentially in the following manner:
As suggested above, the devices carried on the circuit board 17, which is positioned in the upper portion of the internal cavity of the insulator 2, measure the intensity of the current drawn by the line L using the resistive shunt device 5-7. The control and processing unit 12 sends corresponding data to the unit 45 positioned in the base 4 of the measuring device 1 via the electrical/optical converter 13, the optical fibre 14 and the optical/electrical converter or receiver 44.

The unit 45 also acquires data indicating the voltage of the line L via the resistive divider 23.

The unit 45 can then calculate the power drawn by the line L, which is essentially proportional to the product of the intensity of the current drawn and of the voltage on the line. Using information on the absorbed power, the unit 45 can also calculate how much energy is being drawn by the line L over a given time period, calculating the integral of the product of the power multiplied by time.

In the event of a surge greater than a predetermined value, the discharger 40 generates a discharge to earth, thereby protecting all of the devices carried on the base 4 of the measuring device 1.

Naturally, notwithstanding the invention principle, the means of implementation and the specific embodiments may vary greatly from that described and illustrated purely by way of a non-limiting example, without thereby moving outside the scope of the invention as defined in the attached claims.

## Claims

1. Device (1) for measuring the electric power delivered to a railway vehicle by a high voltage electric supply line (L), comprising:
current sensing means (5-7) connected operationally to said supply line (L),
a resistive voltage divider (23) connected operationally between said supply line (L) and an electric earthing terminal (22; 32c),
first processing means (9-13) connected to said current sensing means (5-7) and designed to generate signals or data indicating the intensity of the current drawn by the vehicle from the supply line (L), and
second processing means (41-45) connected to the output (28) of said voltage divider (23) and designed to generate signals or data indicating the voltage of said supply line (L),
said current sensing means (5-7) and the associated first processing means (9-13), as well as the voltage divider (23) being arranged in a cavity (18) inside a line insulator (2), wherein
the terminal (28) with the lowest potential of the voltage divider (23) is connected to a plate-like member (30) made of electrically conductive material that extends outside the cavity (18) of said insulator (2),
**characterised in that**
at a lower end of said insulator (2) there is connected a hollow body (32) made of electrically conductive material, adapted to be connected to earth and in which there are arranged said second processing means (41-45), said hollow body (32) including a plate-like wall (32a) arranged to face said plate-like member (30) at a predetermined distance therefrom, such as to form therewith a discharger (40) capable of generating an electric discharge when the voltage at the ends of same exceeds a predetermined value.

2. Device according to Claim 1, wherein for supplying power to said first processing means (9-13) there is provided a laser radiation generator (60), carried by said hollow body (32) and coupled with said processing means (9-13) by an optical fibre (20) that extends in the cavity (18) of said line insulator (2).

3. Device according to Claim 2, wherein the laser radiation generating device (60) is arranged in an external seat (32f) of said hollow body (32), which is closed by a cover (61) removably fastened to said hollow body (32).

## Patentansprüche

1. Vorrichtung (1) zum Messen der elektrischen Leistung, die einem Schienenfahrzeug durch eine elektrische Hochspannungsversorgungsleitung (L) zugeführt wird, umfassend:
Stromerfassungsmittel (5-7), die betriebsmäßig mit der Versorgungsleitung (L) verbunden sind,
einen Widerstandsspannungsteiler (23), der betriebsmäßig zwischen der Versorgungsleitung (L) und einem elektrischen Erdungsanschluss (22; 32c) verbunden ist,
erste Verarbeitungsmittel (9-13), die mit den Stromerfassungsmitteln (5-7) verbunden sind und dazu ausgelegt sind, Signale oder Daten zu erzeugen, welche die Intensität des vom Fahrzeug aus der Versorgungsleitung (L) gezogenen Stroms angeben, und
zweite Verarbeitungsmittel (41-45), die mit dem Ausgang (28) des Spannungsteilers (23) verbunden sind und dazu ausgelegt sind, Signale oder Daten zu erzeugen, welche die Spannung der Versorgungsleitung (L) angeben,
wobei die Stromerfassungsmittel (5-7) und die zugehörigen ersten Verarbeitungsmittel (9-13) sowie der Spannungsteiler (23) in einem Hohlraum (18) innerhalb eines Leitungsisolators (2) angeordnet sind,
wobei
der Anschluss (28) mit dem niedrigsten Potential des Spannungsteilers (23) mit einem plattenartigen Glied (30) aus elektrisch leitfähigem Material verbunden ist, das sich außerhalb des Hohlraums (18) des Isolators (2) erstreckt, und
**dadurch gekennzeichnet, dass**
an einem unteren Ende des Isolators (2) ein Hohlkörper (32) aus elektrisch leitfähigem Material verbunden ist, der angepasst ist, mit Masse verbunden zu sein bzw. zu werden, und in dem die zweiten Verarbeitungsmittel (41-45) angeordnet sind, wobei der Hohlkörper (32) eine plattenartige Wand (32a) enthält, die so angeordnet ist, dass sie dem plattenartigen Glied (30) mit einem vorbestimmten Abstand dazu gegenüberliegt, um damit einen Entlader (40) zu bilden, der in der Lage ist, eine elektrische Entladung zu erzeugen, wenn die Spannung an den Enden davon einen vorgegebenen Wert überschreitet.

2. Vorrichtung nach Anspruch 1, wobei zur Leistungsversorgung der ersten Verarbeitungsmittel (9-13) ein Laserstrahlungsgenerator (60) bereitgestellt ist, der durch den Hohlkörper (32) getragen und mit den Verarbeitungsmitteln (9-13) durch eine optische Faser (20) gekoppelt ist, die sich in dem Hohlraum (18) des Leitungsisolators (2) erstreckt.

3. Vorrichtung nach Anspruch 2, wobei die Laserstrahlungserzeugungsvorrichtung (60) in einem externen Sitz (32f) des Hohlkörpers (32) angeordnet ist, der durch eine Abdeckung (61) verschlossen ist, die entfernbar an dem Hohlkörper befestigt ist (32).

## Revendications

1. Dispositif (1) pour mesurer la puissance électrique distribuée à un véhicule de chemin de fer par une ligne d'alimentation électrique à haute tension (L), comprenant :
des moyens de détection de courant (5-7) connectés de manière fonctionnelle à ladite ligne d'alimentation (L),
un diviseur de tension résistif (23) connecté de manière fonctionnelle entre ladite ligne d'alimentation (L) et une borne électrique de mise à la terre (22 ; 32c),
des premiers moyens de traitement (9-13) connectés auxdits moyens de détection de courant (5-7) et conçus pour générer des signaux ou des données indiquant l'intensité du courant prélevé par le véhicule sur la ligne d'alimentation (L), et
des seconds moyens de traitement (41-45) connectés à la sortie (28) dudit diviseur de tension (23) et conçus pour générer des signaux ou des données indiquant la tension de ladite ligne d'alimentation (L),
lesdits moyens de détection de courant (5-7) et les premiers moyens de traitement associés (9-13) ainsi que le diviseur de tension (23) étant agencés dans une cavité (18) à l'intérieur d'un isolateur de ligne (2), dans lequel
la borne (28) ayant le potentiel le plus faible du diviseur de tension (23) est connectée à un élément de type plaque (30) constitué d'un matériau électriquement conducteur qui s'étend à l'extérieur de la cavité (18) dudit isolateur (2),
**caractérisé en ce que**
au niveau d'une extrémité inférieure dudit isolateur (2), un corps creux (32) constitué de matériau électriquement conducteur est connecté, conçu pour être connecté à la terre et dans lequel lesdits seconds moyens de traitement (41-45) sont agencés, ledit corps creux (32) incluant une paroi de type plaque (32a) agencée pour faire face audit élément de type plaque (30) à une distance prédéterminée de celui-ci, afin de former avec celui-ci un déchargeur (40) apte à générer une décharge électrique lorsque la tension aux bornes de celui-ci dépasse une valeur prédéterminée.

2. Dispositif selon la revendication 1, dans lequel, pour fournir de la puissance auxdits premiers moyens de traitement (9-13), un générateur de rayonnement laser (60) est fourni, porté par ledit corps creux (32) et couplé auxdits moyens de traitement (9-13) par une fibre optique (20) qui s'étend dans la cavité (18) dudit isolateur de ligne (2).

3. Dispositif selon la revendication 2, dans lequel le dispositif de génération de rayonnement laser (60) est agencé dans un siège externe (32f) dudit corps creux (32), qui est fermé par un couvercle (61) fixé de manière amovible audit corps creux (32).
